(19) **Europäisches Patentamt**
**European Patent Office**
**Office européen des brevets**

(11) **EP 3 317 683 B1**

(12) **EUROPEAN PATENT SPECIFICATION**

(45) Date of publication and mention
of the grant of the patent:
**05.10.2022 Bulletin 2022/40**

(21) Application number: **16818536.1**

(22) Date of filing: **27.06.2016**

(51) International Patent Classification (IPC):
**G01R 31/36** (2020.01)     **G01R 15/12** (2006.01)
**G01R 27/00** (2006.01)     **G01R 27/02** (2006.01)
**G01R 27/08** (2006.01)     **H01M 10/48** (2006.01)
**G01R 31/389** (2019.01)

(52) Cooperative Patent Classification (CPC):
**H01M 10/48; G01R 31/389;** Y02E 60/10

(86) International application number:
**PCT/US2016/039533**

(87) International publication number:
**WO 2017/003917 (05.01.2017 Gazette 2017/01)**

(54) **ENERGY STORAGE CELL IMPEDANCE MEASURING APPARATUS, METHODS AND RELATED SYSTEMS**

VORRICHTUNG ZUR ENERGIESPEICHERZELLENIMPEDANZMESSUNG, VERFAHREN UND ZUGEHÖRIGE SYSTEME

APPAREIL DE MESURE D'IMPÉDANCE DE CELLULE DE STOCKAGE D'ÉNERGIE, PROCÉDÉS ET SYSTÈMES ASSOCIÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.07.2015 US 201514789959**

(43) Date of publication of application:
**09.05.2018 Bulletin 2018/19**

(73) Proprietor: **Battelle Energy Alliance, LLC**
**Idaho Falls, ID 83415-3899 (US)**

(72) Inventors:
• **MORRISON, John L.**
**Butte, Montana 59701 (US)**
• **MORRISON, William H.**
**Butte, Montana 59701 (US)**

• **CHRISTOPHERSEN, Jon P.**
**Moscow, Idaho 83843 (US)**

(74) Representative: **Stuttard, Garry Philip**
**Murgitroyd & Company Leeds**
**Studio 3**
**84 Albion Street**
**Leeds LS1 6AG (GB)**

(56) References cited:
**WO-A1-2015/029647     US-A- 6 002 238**
**US-A1- 2011 270 559     US-A1- 2012 262 186**
**US-A1- 2014 188 414     US-A1- 2014 358 462**
**US-A1- 2014 358 462     US-B2- 8 035 396**
**US-B2- 8 889 309**

## Description

PRIORITY CLAIM

This application claims the benefit of the filing date of United States Patent Application Serial No. 14/789,959, filed July 1, 2015, for "ENERGY STORAGE CELL IMPEDANCE MEASURING APPARATUS, METHODS AND RELATED SYSTEMS." This application is also related to U.S. Patent Application Serial No. 13/438,741, filed April 3, 2012, now U.S. Patent 9,244,130, issued January 26, 2016, which is a continuation of U.S. Patent Application Serial No. 12/217,013, filed June 30, 2008, now U.S. Patent 8,150,643, issued April 3, 2012, which is a continuation-in-part of United States Patent Application No. 11/825,629, filed July 5, 2007, now U.S. Patent 7,395,163, issued July 1, 2008, which is a continuation of United States Patent Application No. 11/313,546, filed December 20, 2005, now abandoned, which claims the benefit of United States Provisional Patent Application Nos. 60/637,969, filed December 20, 2004, and 60/724,631, filed October 7, 2005. This application is also related to United States Patent Application No. 12/813,750, filed June 11, 2010, now U.S. Patent 8,868,363, issued October 21, 2014, which claims priority to United States Provisional Patent Application No. 61/186,358, filed June 11, 2009; and this application is also related to United States Patent Application No. 12/772,880, filed May 3, 2010, now U.S. Patent 8,352,204, issued October 28, 2010, which is a continuation-in-part of United States Patent Application No. 12/217,013, filed June 30, 2008, now U.S. Patent 8,150,643, issued April 3, 2012; and this application is also related to United States Patent Application No. 13/100,170, filed May 3, 2011, which claims priority to United States Provisional Patent Application No. 61/330,766, filed May 3, 2010; and this application is also related to United States Patent Application No. 13/100,184, filed May 3, 2011, now U.S. Patent 8,762,109, issued June 24, 2014, which claims priority to United States Provisional Patent Application No. 61/330,733, filed May 3, 2010.

STATEMENT REGARDING FEDERALLY SPONSORED RESEARCH OR DEVELOPMENT

The invention was made with government support under Contract No. DE-AC07-05-ID14517, awarded by the United States Department of Energy. The government has certain rights in this invention.

BACKGROUND

The present disclosure relates to apparatus and methods for impedance measurement and, more specifically, to impedance measurement in energy storage cells employed in rechargeable service, as well as systems including such cells. Specific applications, without limitation, include impedance measurement of relatively high voltage energy storage cells.

Chemical changes to electrodes in a rechargeable battery may cause degradation in the battery's capacity, and other functional parameters. Battery degradation may accumulate over the life of the battery. Environmental factors (e.g., high temperature) and functional factors (e.g., improper charging and discharging) may accelerate battery degradation. Operators of systems that rely on rechargeable battery power may desire to monitor the degradation of the batteries they use.

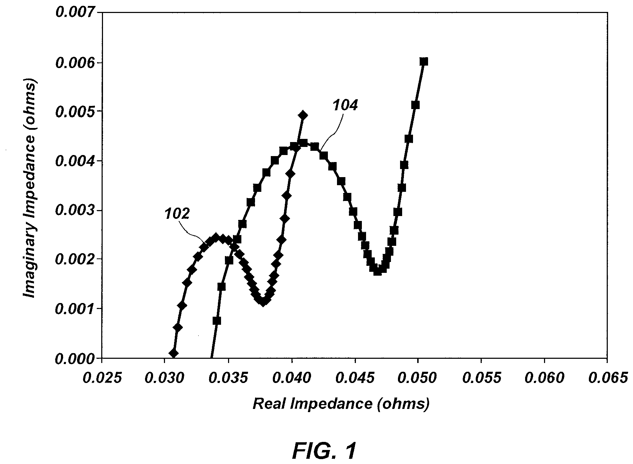

One indicator of battery degradation is an increase in battery impedance. FIG. 1 is an impedance (real and imaginary) plot 102 (similar to a Nyquist plot) of a fresh battery and an impedance plot 104 of an aged battery, measured at several different frequencies using an Electrochemical Impedance Measurement (EIM) system. As illustrated in FIG. 1, the aged battery shows a higher impedance than the fresh battery at each of the different frequencies. Operators of systems that rely on rechargeable batteries may use impedance data, such as the EIM data of FIG. 1, to determine that a replacement battery is needed before a failure occurs. Such preemptive replacement may prevent expensive delays and property damage that may occur in the event of a battery failure. Also, knowledge of a battery's continued reliability may prevent expenses associated with unnecessarily replacing a battery that still has a substantial amount of lifetime left.

EIM systems use the Bode analysis technique to characterize an impedance of an electrochemical process. The Bode analysis technique is a well-established and proven technique. In EIM systems, a battery being evaluated is excited with an AC current of a single frequency, and a response is measured. The process is repeated over a range of frequencies of interest until the spectrum of the impedance is obtained. The EIM method is effective, but time consuming, as the process is serial (e.g., the impedance is measured separately and sequentially for each of the different frequencies of interest).

A parallel approach using bandwidth limited noise as an excitation current to the battery can obtain similar impedance information of the battery in less time. System response to the noise is processed via correlation and Fast Fourier Transform (FFT) algorithms, and many such responses are averaged. The result is the spectrum of response over the desired frequency range. The averaging of many responses makes this process somewhat serial (e.g., separate excitations are sequentially applied to the battery, and respective responses are measured). As a result, this process is also somewhat time consuming, similar to the EIM system discussed above. Another technique assembles the current noise waveform from a sum of sinusoids, each at a different frequency. The system response as a time record is acquired and processed with the FFT algorithm. To reduce noise, multiple time records of waveforms are processed and their resultant spectra are averaged. This process is similarly somewhat serial, and therefore, is also somewhat time consuming.

US-A-2014/358462 discloses an apparatus for testing an electrochemical cell by measuring frequency response.

US-A-2014/0188414 discloses a system for measuring the impedance of a fuel cell stack.

Disclosed in some embodiments herein is an energy storage impedance measuring device including a sum of sinusoids (SOS) current excitation circuit, and control circuitry. The SOS current excitation circuit includes differential current sources configured to isolate a ground terminal of the differential current from a positive terminal and a negative terminal of an energy storage cell. The SOS current excitation circuitry is configured to apply an SOS signal through the energy storage cell. The SOS signal includes a sum of a plurality of sinusoidal current signals. Each of the plurality of sinusoidal current signals oscillates at a different one of a plurality of different frequencies. The control circuitry is configured to operably couple to the SOS current excitation circuit, the positive terminal, and the negative terminal. The control circuitry includes an SOS control module, at least one signal measuring module, and an impedance computation module. The SOS control module is configured to cause the SOS current excitation circuit to produce the SOS signal. The at least one signal measuring module is configured to measure electrical signals on the positive terminal and the negative terminal of the battery cell. The impedance computation module is configured to use the electrical signals measured by the at least one signal measuring module to compute an impedance of the battery for each frequency of the SOS signal.

Disclosed in some embodiments herein is a method of measuring impedance of an energy storage cell. The method includes applying a sum-of-sinusoids (SOS) signal including a sum of sinusoidal current signals to an energy storage cell with an SOS current excitation circuit including differential current sources. Each of the sinusoidal current signals oscillates at a different one of a plurality of different frequencies. The method also includes measuring an electrical signal at a positive terminal and a negative terminal of the energy storage cell. The method further includes computing an impedance of the energy storage cell at each of the plurality of different frequencies using the measured electrical signal.

Disclosed in some embodiments herein is an energy storage cell impedance measuring circuit including differential current sources and a high voltage buffer. The differential current sources include a push current source configured to operably couple to a positive terminal of an energy storage cell, a pull current source configured to operably couple to a negative terminal of the energy storage cell, and a ground terminal of the differential current sources operably coupled between the push current source and the pull current source. The high voltage buffer is operably coupled to at least one of the push current source and the pull current source. The high voltage buffer is configured to isolate the at least one of the push current source and the pull current source form a direct current voltage provided by the energy storage cell. The differential current source is configured to apply a sum-of-sinusoids (SOS) signal through the positive terminal and the negative terminal of the energy storage cell.

Disclosed in some embodiments herein is an impedance measuring system. The impedance measuring system includes one or more energy storage cells, and an energy storage cell impedance measuring system operably coupled to the one or more energy storage cells. The energy storage cell impedance measuring system includes sum-of-sinusoids (SOS) current excitation circuitry including differential current sources. The SOS current excitation circuitry is configured to apply SOS signals to the one or more energy storage cells. The SOS signals include sums of a plurality of sinusoidal current signals. Each of the plurality of sinusoidal current signals include a different one of a plurality of different frequencies. The energy storage cell impedance measuring system also includes control circuitry operably coupled to the SOS current excitation circuit and the one or more energy storage cells. The control circuitry is configured to control the SOS current excitation circuitry, measure electrical signals at terminals of the one or more energy storage cells responsive to the SOS signals, and compute impedances of the energy storage cells.

BRIEF DESCRIPTION OF THE DRAWINGS

FIG. 1 is an impedance plot of a fresh battery and an impedance plot of an aged battery, measured at several different frequencies using an Electrochemical Impedance Measurement (EIM) system;

FIG. 2 is a simplified block diagram of an energy storage cell impedance measuring system;

FIG. 3A is a simplified block diagram of a control circuitry of FIG. 2;

FIG. 3B is another simplified block diagram of the control circuitry of FIG. 2, according to some embodiments of the disclosure;

FIG. 4A is a simplified circuit schematic illustration of the SOS current excitation circuitry of FIG. 2;

FIG. 4B is a simplified equivalent circuit schematic illustration of the SOS current excitation circuitry of FIG. 4A;

FIG. 5 is a simplified circuit schematic diagram of a high voltage buffer operably coupled to the SOS current excitation circuitry of FIG. 4B, and an energy storage cell of FIG. 2, according to a single coupling capacitor embodiment of the high voltage buffer of FIG. 2;

FIG. 6 is a simplified circuit schematic diagram of a high voltage buffer operably coupled to the SOS current excitation circuitry of FIG. 4B, and an energy storage cell of FIG. 2, according to a double coupling capacitor embodiment of the high voltage buffer of FIG. 2;
FIG. 7 is a simplified flowchart illustrating a method of measuring impedance of an energy storage cell;
FIG. 8 is a simplified flowchart illustrating an example method of calibrating the control circuitry of the energy storage cell impedance measuring system of FIG. 2; and
FIG. 9 is a simplified block diagram of an impedance measuring system.

MODE(S) FOR CARRYING OUT THE INVENTION

In the following detailed description, reference is made to the accompanying drawings, which form a part hereof, and in which is shown by way of illustration specific embodiments in which the present disclosure may be practiced. These embodiments are described in sufficient detail to enable those of ordinary skill in the art to practice the present disclosure. It should be understood, however, that the detailed description and the specific examples, while indicating examples of embodiments of the present disclosure, are given by way of illustration only and not by way of limitation. From this disclosure, various substitutions, modifications, additions rearrangements, or combinations thereof within the scope of the present disclosure may be made and will become apparent to those of ordinary skill in the art.

In accordance with common practice, the various features illustrated in the drawings may not be drawn to scale. The illustrations presented herein are not meant to be actual views of any particular apparatus (e.g., device, system, etc.) or method, but are merely idealized representations that are employed to describe various embodiments of the present disclosure. Accordingly, the dimensions of the various features may be arbitrarily expanded or reduced for clarity. In addition, some of the drawings may be simplified for clarity. Thus, the drawings may not depict all of the components of a given apparatus or all operations of a particular method.

Information and signals described herein may be represented using any of a variety of different technologies and techniques. For example, data, instructions, commands, information, signals, bits, symbols, and chips that may be referenced throughout the description may be represented by voltages, currents, electromagnetic waves, magnetic fields or particles, optical fields or particles, or any combination thereof. Some drawings may illustrate signals as a single signal for clarity of presentation and description. It should be understood by a person of ordinary skill in the art that the signal may represent a bus of signals, wherein the bus may have a variety of bit widths and the present disclosure may be implemented on any number of data signals including a single data signal.

The various illustrative logical blocks, modules, circuits, and algorithm acts described in connection with embodiments disclosed herein may be implemented as electronic hardware, computer software, or combinations of both. To clearly illustrate this interchangeability of hardware and software, various illustrative components, blocks, modules, circuits, and acts are described generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the embodiments of the disclosure described herein.

In addition, it is noted that the embodiments may be described in terms of a process that is depicted as a flowchart, a flow diagram, a structure diagram, or a block diagram. Although a flowchart may describe operational acts as a sequential process, many of these acts can be performed in another sequence, in parallel, or substantially concurrently. In addition, the order of the acts may be rearranged. A process may correspond to a method, a function, a procedure, a subroutine, a subprogram, etc. Furthermore, the methods disclosed herein may be implemented in hardware, software, or both. If implemented in software, the functions may be stored or transmitted as one or more computer-readable instructions (e.g., software code) on a computer-readable medium. Computer-readable media may include both computer storage media and communication media including any medium that facilitates transfer of a computer program from one place to another. Computer-readable media may include volatile and non-volatile memory, such as, for example, magnetic and optical storage devices, such as, for example, hard drives, disk drives, magnetic tapes, CDs (compact discs), DVDs (digital versatile discs or digital video discs), solid state storage devices (solid state drives), and other similar storage devices.

It should be understood that any reference to an element herein using a designation such as "first," "second," and so forth does not limit the quantity or order of those elements, unless such limitation is explicitly stated. Rather, these designations may be used herein as a convenient method of distinguishing between two or more elements or instances of an element. Thus, a reference to first and second elements does not mean that only two elements may be employed there or that the first element must precede the second element in some manner. Also, unless stated otherwise a set of elements may comprise one or more elements.

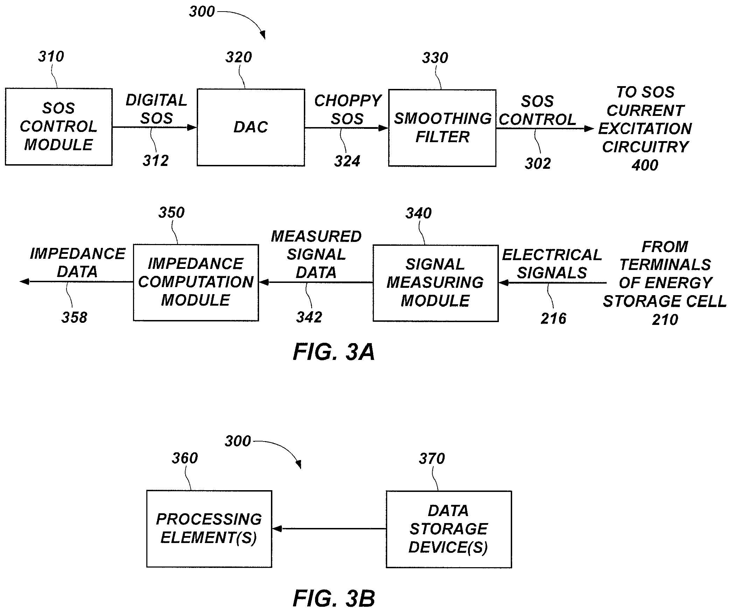

Elements described herein may include multiple instances of the same element. These elements may be generically indicated by a numerical designator (e.g., 500) and specifically indicated by the numerical indicator followed by a numeric indicator followed by a letter (e.g., 500A). For ease of following the description, for the most part, element number indicators begin with the number of the drawing on which the elements are introduced or most fully discussed. Thus, for example, element identifiers on a FIG. 1 will be mostly in the numerical format 1xx and elements on a FIG. 3 will be mostly in the numerical format 3xx.

As used herein, the terms "energy storage cell" and "energy storage cells" refer to rechargeable electrochemical cells that convert chemical energy to a direct current electrical voltage potential across a positive terminal and a negative terminal of the energy storage cell. The terms "battery," "cell," and "battery cell" may be used interchangeably herein with the term "energy storage cell."

As used herein, the terms "sinusoid," and "sinusoidal," refer to electrical signals (e.g., currents and voltage potentials) that oscillate at least substantially according to a sine or cosine function (e.g., having various magnitudes and phase shifts) over time. As should be readily apparent to those of ordinary skill in the art, any given sinusoidal signal may be equivalently expressed either as a sine function or a cosine function, as the sine and cosine are merely phase-shifted versions of each other. Sinusoidal signals are disclosed herein as being applied to energy storage cells and shunts (e.g., resistors of known resistance values for calibration purposes). In some cases, these sinusoidal signals are referred to more specifically herein as either sine signals or cosine signals. These specific references to sine signals and cosine signals may be indicative of the phase of such signals relative to a time when a sinusoidal signal is first asserted to a conductive line (e.g., a positive or negative battery terminal, a conductive trace on a circuit board, a wire, etc.).

As used herein, the term "sum-of-sinusoids" ("SOS") refers to electrical signals that oscillate according to a sum of sinusoidal signals. An SOS signal may include sums of sine signals, sums of cosine signals, or combinations thereof. For example, a harmonic orthogonal synchronous transform (HOST) SOS may include a base sinusoidal signal having a base frequency summed with one or more sinusoidal signals having successive integer harmonic frequencies of the base frequency, and alternating between sine signals and cosine signals (or some phase-shifted version thereof) for each successive harmonic. The orthogonal nature of the harmonic sinusoidal signals summed together in a HOST SOS may serve to reduce or eliminate excessive transients.

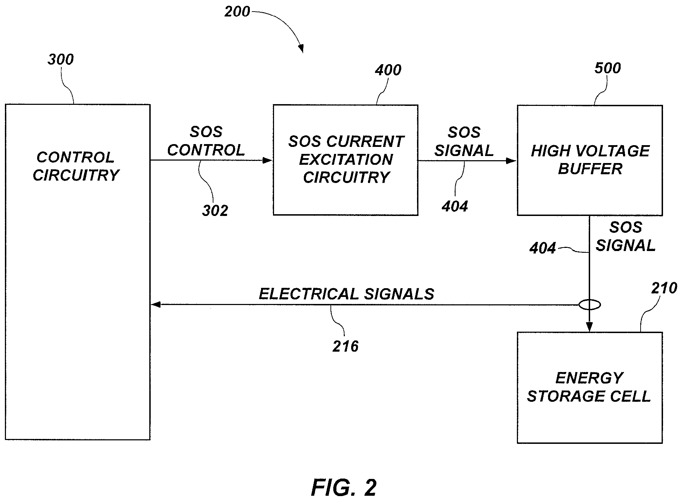

FIG. 2 is a simplified block diagram of an energy storage cell impedance measuring system 200. The energy storage cell impedance measuring system 200 may include control circuitry 300 operably coupled to SOS current excitation circuitry 400 and an energy storage cell 210. The energy storage cell impedance measuring system 200 may also include a high voltage buffer 500 operably coupled between the SOS current excitation circuitry 400 and the energy storage cell 210.

The control circuitry 300 may be configured to control the SOS current excitation circuitry 400. By way of non-limiting example, the control circuitry 300 may be configured to apply an SOS control signal 302 to the SOS current excitation circuitry 400 to control an SOS signal 404 outputted by the SOS current excitation circuitry 400. The SOS control signal 302 may be selected to cause the SOS current excitation circuitry 400 to provide an SOS signal 404 including a sum of a plurality of different current signals (e.g., a HOST SOS signal) having a plurality of different frequencies of interest for testing impedance of the energy storage cell 210. In some embodiments, the SOS control signal 302 may include a voltage signal proportional to a desired current signal for the SOS signal 404 at the output of the SOS current excitation circuitry 400. Accordingly, the SOS control signal 302 may include an SOS voltage signal.

The control circuitry 300 may also be operably coupled to the energy storage cell 210 and configured to measure electrical signals 216 at terminals of the energy storage cell 210 responsive to an SOS signal 404 applied to the terminals of the energy storage cell 210. The control circuitry 300 may be configured to compute the impedance of the energy storage cell 210 at the frequencies of the SOS signal using the measured electrical signals 216. In this way, the control circuitry 300 may be configured to work with the SOS current excitation circuitry 400 to test the impedance of the energy storage cell 210 at a plurality of different frequencies substantially simultaneously.

In some embodiments, the control circuitry 300 may be configured to measure a voltage response and a current response of the energy storage cell 210 to the SOS signal 404, and divide the measured voltage response by the measured current response to obtain the impedance response of the energy storage cell 210. In such embodiments, no calibration may be needed because the impedance of the energy storage cell 210 may be determined by dividing a measured voltage by a measured current.

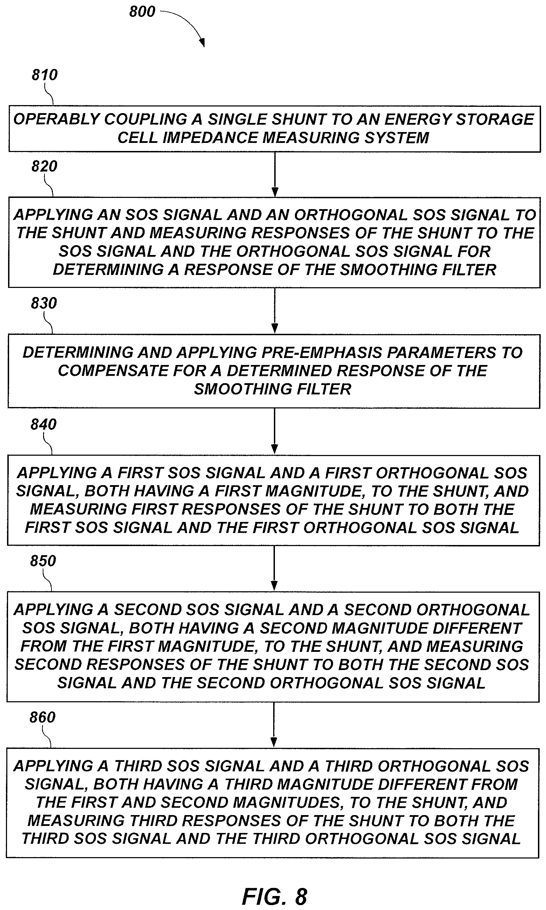

In some embodiments, the control circuitry 300 may be configured to measure only a voltage response of the energy storage cell 210 to the SOS signal 404. In such embodiments, calibration may be needed to determine the impedance of the energy storage cell 210. By way of non-limiting example, a method of single-shunt calibration is discussed below with reference to FIG. 8. In some embodiments, multiple shunt (e.g., resistive shunts) calibration may be used to account for real and imaginary portions of signals.

More detail regarding the control circuitry 300 will be discussed below with reference to FIGS. 3A and 3B.

The SOS current excitation circuitry 400 may be configured to receive the SOS control signal 302 from the control circuitry 300 and generate an SOS signal 404. The SOS current excitation circuitry 400 may be configured to apply the SOS signal 404 to the energy storage cell 210. In some embodiments, the SOS current excitation circuitry 400 may be configured to apply the SOS signal 404 to the energy storage cell 210 through the high voltage buffer 500. It should be noted that the impedance of the energy storage cell 210 may, in some embodiments, be determined without the high voltage buffer 500. By way of non-limiting example, U.S. Patent Publication No. 2012/0262186 to Morrison et al., filed April 3, 2012 discloses measuring impedance of an energy storage device without such a high voltage buffer 500.

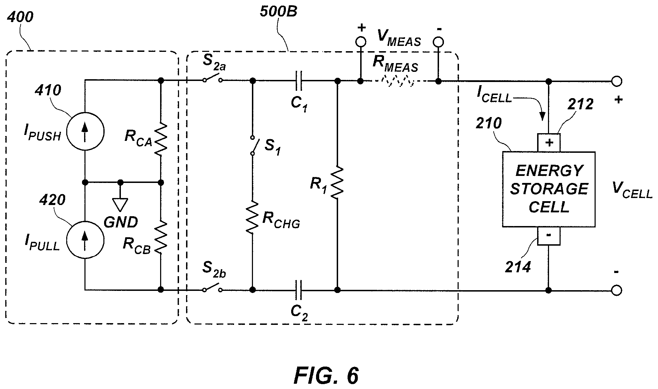

The SOS signal 404 may include a sum of sinusoidal current signals having frequencies of interest for energy storage cell 210 impedance measurements. In some embodiments, the SOS current excitation circuitry 400 may include differential current sources including a push current source configured to push current into the energy storage cell 210 and a pull current source configured to pull current from the energy storage cell 210. The push current source and the pull current source may each include an operational amplifier current source, and form a balanced differential current source, as will be discussed in more detail below with reference to FIG. 6.

The high voltage buffer 500 may be configured to isolate at least one signal line of the SOS current excitation circuitry 400 providing the SOS signal 404 from a direct current voltage sourced by the energy storage cell 210. Accordingly, an analog ground of the SOS current excitation circuitry 400 may be electrically isolated from a power terminal of the energy storage cell 210. As a result, sensitive electronics included in the SOS current excitation circuitry 400 may not be exposed to the extremes of the direct current voltage potential sourced by the energy storage cell 210. Also, the SOS current excitation circuitry 400 may be subjected to less noise than if the analog ground were extended outside of the SOS current excitation circuitry 400.

The high voltage buffer 500 may also be configured to pass the SOS signal 404 to the energy storage cell 210. In some embodiments, the high voltage buffer 500 may include a high-pass filter. In some embodiments, the high voltage buffer 500 may include at least one capacitor operably coupled in series between the SOS current excitation circuitry 400 and the energy storage cell 210.

In operation, the control circuitry 300 may provide the SOS control signal 302 to the SOS current excitation circuitry 400. The SOS control signal 302 may cause the SOS current excitation circuitry 400 to output an SOS signal 404 (e.g., a HOST SOS signal). The high voltage buffer 500 may pass the SOS signal 404 to the terminals of the energy storage cell 210, while buffering the SOS current excitation circuitry 400 from the direct current voltage potential sourced by the energy storage cell 210. Electrical signals 216 (e.g., a voltage response, a current response, or a combination thereof) at terminals of the energy storage cell 210 responsive to the SOS signal 404 may be measured by the control circuitry 300. The control circuitry 300 may determine the impedance of the energy storage cell 210 at each of the plurality of frequencies of the SOS signal 404 by analyzing the electrical signals 216.

FIG. 3A is a simplified block diagram of the control circuitry 300 of FIG. 2. The control circuitry 300 may include an SOS control module 310, a digital-to-analog converter (DAC) 320, a smoothing filter 330, a signal measuring module 340, and an impedance computation module 350. The SOS control module 310 may be configured to generate a digital SOS signal 312 including a sum of sinusoids having a plurality of different frequencies that are of interest for impedance measurement of an energy storage cell 210 (FIG. 2). The digital SOS signal 312 may be sampled at least at a Nyquist rate of a highest one of the plurality of different frequencies of the digital SOS signal 312. The digital SOS signal 312 may also represent at least one period of a lowest one of the plurality of different frequencies of the digital SOS signal 312. The SOS control module 310 may be configured to provide the digital SOS signal 312 to the DAC 320.

The DAC 320 may be configured to convert the digital SOS signal 312 to a choppy SOS signal 324. As those of ordinary skill in the art should understand, digital signals, such as the digital SOS signal 312, are only capable of manifesting a discrete set of discontinuous signal levels. As a result, when digital signals are converted to analog signals, the analog equivalent manifests stepwise, or "choppy" fluctuations. Thus, the choppy SOS signal 324 provided by the DAC 320 may manifest stepwise fluctuations. The DAC 320 may be configured to provide the choppy SOS signal 324 to the smoothing filter 330.

The smoothing filter 330 may be configured to smooth the choppy SOS signal 324 to provide a smooth SOS control signal 302. By way of non-limiting example, the smoothing filter 330 may include a low-pass filter configured to smooth the stepwise fluctuations of the choppy SOS signal 324. The SOS control signal 302 may be provided to the SOS current excitation circuitry 400 (FIG. 2).

As should be appreciated by those of ordinary skill in the art, a filter may alter a magnitude, phase, or combination thereof, of periodic signals. It should also be appreciated that filters may alter the magnitude and phase of different components of signals oscillating at different frequencies in different ways. Accordingly, each of the different frequency components of the SOS control signal 302 may be altered in magnitude, frequency, or a combination thereof, from the corresponding magnitude and frequency of the different frequency components of the digital SOS signal 312, due at least in part to the smoothing filter 330.

In some embodiments, properties of the smoothing filter 330 may be known to analytically estimate the frequency response of smoothing filter 330. In some embodiments, calibration may be used to determine the frequency response to the smoothing filter 330. The SOS control module 310 may use the frequency response of the smoothing filter 330 to take into account expected changes in magnitude, phase, or a combination thereof, that the smoothing filter 330 is expected to impose on the different frequency components of the control signal 302. The SOS control module 310 may compensate for the expected changes when generating the digital SOS signal 312. In other words, the SOS control module 310 may be configured to pre-emphasize the digital SOS signal 312 to compensate for the response of the smoothing filter 330. By way of non-limiting example, if the smoothing filter 330 is expected to attenuate and shift a first frequency component of the choppy SOS signal 324 by known amounts, the SOS control module 310 may preemptively increase the magnitude and shift the phase of the corresponding first frequency component of the digital SOS signal 312 by the known amounts to compensate for the expected changes.

Once the SOS control signal 302 has been provided to the SOS current excitation circuitry 400, and a corresponding SOS signal 404 (FIG. 2) is applied to the energy storage cell 210, the signal measuring module 340 may measure electrical signals 216 at the terminals of the energy storage cell 210. By way of non-limiting example, the signal measuring module 340 may be configured to measure a voltage response of the energy storage cell 210 to the SOS signal 404, a current response of the energy storage cell 210 to the SOS signal 404, or a combination thereof. The signal measuring module 340 may be configured to provide the impedance computation module 350 measured signal data 342 indicating the measured response of the energy storage cell 210 to the SOS signal 404.

The impedance computation module 350 may be configured to compute a determined impedance of the energy storage cell 210 using the measured signal data 342 from the signal measuring module 340. By way of non-limiting example, the measured signal data may include both the voltage response and the current response of the energy storage cell 210 to the SOS signal 404 (FIG. 2). The impedance computation module 350 may be configured to divide the voltage response by the current response for each of the plurality of different frequencies of the SOS signal 404 to determine the impedance for each of the plurality of different frequencies.

Also by way of non-limiting example, the measured signal data 342 may include only the voltage response of the energy storage cell 210 to the SOS signal 404. The impedance computation module 350 may be configured to estimate the current response using the voltage response and calibration data from previous or subsequent calibrations of the control circuitry 300. A known calibration response may be measured by applying the SOS signal 404 to one or more shunts of known impedance, and measuring and storing calibration data including the response of the one or more shunts to the SOS signal 404. For example, a method for calibrating the control circuitry 300 using a single shunt is discussed below with reference to FIG. 8.

The impedance computation module 350 may be configured to provide or store impedance data including the determined impedance of the energy storage cell 210 at each of the frequencies included in the digital SOS signal 312 (i.e., the same frequencies included in the choppy SOS signal 324, the SOS control signal 302, and the SOS signal 404). In some embodiments, the impedance data may be displayed to a user of the energy storage cell impedance measuring system 200 (FIG. 2) (e.g., on an electronic display of the energy storage cell impedance measuring system 200 in list form, in plot form, in table form, etc.). In some embodiments, the impedance data may be processed automatically to determine whether the energy storage cell 210 should be replaced, and the user may be informed of the automatic determination. In some embodiments, the impedance data may be processed automatically to determine an estimate of how much life is remaining to the energy storage cell 210. Such automatic processing may be performed locally by the control circuitry 300 (e.g., by processing elements 360 operably coupled to data storage devices 370 (FIG. 3B)), remotely by a computing device (e.g., a personal computer, a tablet, a smart phone, a server, an automobile computer, other computing devices, etc.) configured to communicate with the control circuitry 300, or combinations thereof.

FIG. 3B is another simplified block diagram of the control circuitry 300 of FIG. 2, according to some embodiments of the disclosure. In some embodiments, the control circuitry 300 may include at least one processing element 360 operably coupled to at least one data storage device 370. The data storage device 370 may include computer-readable instructions configured to instruct the at least one processing element 360 to perform the functions of at least one of the SOS control module 310, the digital-to-analog converter 320, the smoothing filter 330, the signal measuring module 340, and the impedance computation module 350.

The at least one processing element 360 may include an electrical circuit configured to execute the computer-readable instructions stored in the at least one data storage device 370. By way of non-limiting example, the at least one processing element 360 may include a microcontroller, a central processing unit (CPU), a programmable logic controller (PLC), a digital signal processor (DSP), other processing elements, and combinations thereof. In some embodiments, the at least one processing element 360 may be implemented in a same semiconductor package as the at least one data storage device 370 (e.g., a microcontroller with on-board memory, etc.). In some embodiments, the at least one processing element 360 may be implemented in separate packages from the at least one data storage device 370.

The at least one data storage device 370 may include volatile (e.g., random access memory (RAM)) or non-volatile (e.g., read-only memory (ROM)) data storage. By way of non-limiting example, the at least one data storage device 370 may include Flash memory, a hard disk, a solid state drive, cloud storage, electrically programmable read-only memory (EPROM), other data storage, and combinations thereof.

In some embodiments, the control circuitry 300 may include one or more hardware implemented modules. By way of non-limiting example, at least one of the SOS control module 310, the DAC 320, the smoothing filter 330, the signal measuring module 340, and the impedance computation module 350 may be implemented in hardware (e.g., a system on chip (SoC), an application specific integrated circuit (ASIC), a circuit built from discrete circuit components, etc.).

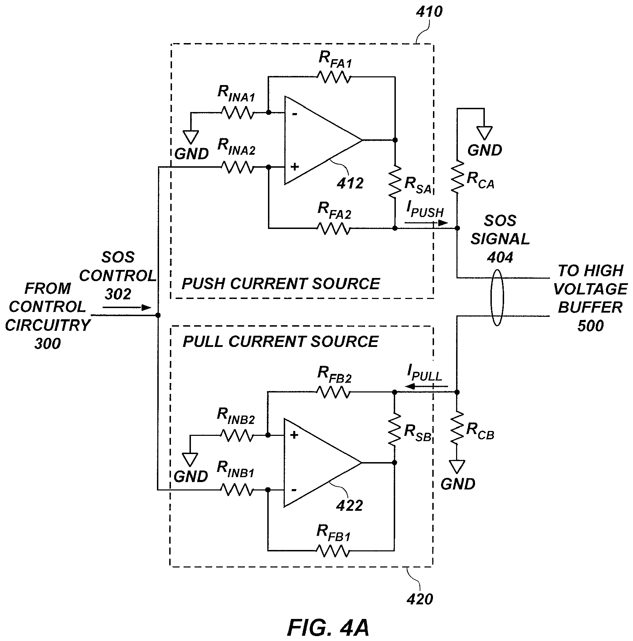

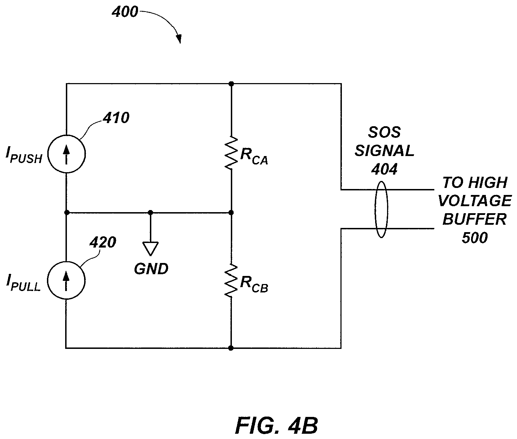

FIG. 4A is a simplified circuit schematic illustration of the SOS current excitation circuitry 400 of FIG. 2. FIG. 4B is a simplified equivalent circuit schematic illustration of the SOS current excitation circuitry 400 of FIG. 4A. Referring to FIGS. 4A and 4B together, the SOS current excitation circuitry 400 may include a push current source 410 and a pull current source 420 (i.e., a push-pull current driver, also referred to herein as "differential current sources" 410, 420). The push current source 410 may be configured to push current $I_{PUSH}$ into the energy storage cell 210 (FIG. 2), and the pull current source 420 may be configured to pull current $I_{PULL}$ from the energy storage cell 210 (e.g., through the high voltage buffer 500). As is apparent from FIG. 4B, the analog ground terminal GND of the SOS current excitation circuitry 400 is floated between the push current source 410 and the pull current source 420, isolating the analog ground terminal GND from the terminals of the energy storage cell 210. The push current source 410 and the pull current source 420 may be high impedance current sources. As a result, the SOS current excitation circuitry 400 may be fully high impedance ground isolated.

The push current source 410 and the pull current source 420 may be configured to receive the SOS control signal 302 and provide the SOS signal 404 to the high voltage buffer 500. The SOS signal 404 may include a current signal that is proportional to a voltage potential of the SOS control signal 302, as will be discussed in more detail below.

In some embodiments, the push current source 410 may include an operational amplifier 412 operably coupled to resistors $R_{INA1}$, $R_{INA2}$, $R_{FA1}$, $R_{FA2}$, and $R_{SA}$ in an operational amplifier current source configuration. Input resistors $R_{INA1}$ and $R_{INA2}$ may be operably coupled to the inverting input and the non-inverting input, respectively, of the operational amplifier 412. The non-inverting input of the operational amplifier 412 may be configured to receive the SOS control signal 302 through the resistor $R_{INA2}$. The inverting input of the operational amplifier 412 may be operably coupled to analog ground GND through resistor $R_{INA1}$. Resistors $R_{INA1}$ and $R_{INA2}$ may be selected to have the same resistance value $R_{INA}$.

The inverting input of the operational amplifier 412 may also be operably coupled to an output of the operational amplifier 412 through resistor $R_{FA1}$. The non-inverting input of the operational amplifier 412 may be operably coupled to the output of the operational amplifier 412 through resistors $R_{FA2}$ and $R_{SA}$. The resistance of

$R_{FA1}$ and $R_{FA2}$ may be selected to have the same resistance value $R_{FA}$. An output of the push current source 410 may be located between resistors $R_{FA2}$ and $R_{SA}$. Accordingly, a push portion of the SOS signal 404 may be provided between resistors $R_{FA2}$ and $R_{SA}$. Thus configured, the push portion of the SOS signal 404 provided by the push current source 410 may be expressed as:

$$I_{PUSH} = V_{SOSCONTROL} \frac{R_{FA}}{R_{INA}R_{SA}},$$

where $I_{PUSH}$ is the current provided by the push current source 410, and $V_{SOSCONTROL}$ is the voltage potential of the SOS control signal 302. As may be seen by inspecting this expression, the $I_{PUSH}$ is proportional to $V_{SOS\,CONTROL}$.

In some embodiments, the pull current source 420 may include an operational amplifier 422 operably coupled to resistors $R_{INB1}$, $R_{INB2}$, $R_{FB1}$, $R_{FB2}$, and $R_{SB}$ in an operational amplifier current source configuration. Input resistors $R_{INB1}$ and $R_{INB2}$ may be operably coupled to the inverting input and the non-inverting input, respectively, of the operational amplifier 422. The inverting input of the operational amplifier 422 may be configured to receive the SOS control signal 302 through the resistor $R_{INB1}$. The non-inverting input of the operational amplifier 422 may be operably coupled to analog ground GND through resistor $R_{INB2}$. Resistors $R_{INB1}$ and $R_{INB2}$ may be selected to have the same resistance value $R_{INB}$.

The inverting input of the operational amplifier 422 may also be operably coupled to an output of the operational amplifier 422 through resistor $R_{FB1}$. The non-inverting input of the operational amplifier 412 may be operably coupled to the output of the operational amplifier 422 through resistors $R_{FB2}$ and $R_{SB}$. The resistance of $R_{FB1}$ and $R_{FB2}$ may be selected to have the same resistance value $R_{FB}$. An output of the pull current source 420 may be located between resistors $R_{FB2}$ and $R_{SB}$. Accordingly, a pull portion $I_{PULL}$ of the SOS signal 404 may be pulled from by a node between resistors $R_{FB2}$ and $R_{SB}$. Thus configured, the pull portion $I_{PULL}$ of the SOS signal 404 pulled by the pull current source 420 may be expressed as:

$$I_{PULL} = V_{SOSCONTROL} \frac{R_{FB}}{R_{INB}R_{SB}},$$

where $I_{PULL}$ is the current pulled by the pull current source 420, and $V_{SOSCONTROL}$ is the voltage potential of the SOS control signal 302. As is apparent from inspection of this expression, $I_{PULL}$ is proportional to $V_{SOS\,CONTROL}$.

As is apparent from FIG. 4B, the push current source 410 and the pull current source 420 are operably coupled in series (i.e., through the high voltage buffer 500 and the energy storage cell 210). Those of ordinary skill in the art will appreciate that current sources operably coupled in series, such as the push current source 410 and the pull current source 420, must both provide the same amount of current in the same direction. Accordingly, the resistor values $R_{INA}$, $R_{INB}$, $R_{FA}$, $R_{FB}$, $R_{SA}$, and $R_{SB}$ may be selected to make $I_{PUSH}$ equal to $I_{PULL}$.

Those of ordinary skill in the art will also appreciate that it may be difficult to exactly match the components of the push current source 410 to the components of the pull current source 420. In order to compensate for this issue, extra resistors $R_{CA}$ and $R_{CB}$ may be operably coupled in parallel across the push current source 410 and the pull current source 420, respectively. The extra resistors $R_{CA}$ and $R_{CB}$ may be configured to enable extra currents resulting from mismatches between the push current source 410 and the pull current source 420 to dissipate to ground through the extra resistors $R_{CA}$ and $R_{CB}$. Also, as the values of resistors $R_{SA}$ and $R_{SB}$ are not factored into the equations above for $I_{PULL}$ and $I_{PUSH}$, the values of $R_{SA}$ and $R_{SB}$ may be adjusted without creating a mismatch between the push current source 410 and the pull current source 420. Accordingly, in some embodiments, resistors $R_{SA}$ and $R_{SB}$ may be provided as potentiometers that may be adjusted empirically until the push current source 410 and the pull current source 420 achieve adequate matching.

Assuming that the push current source 410 and the pull current source 420 are well balanced, the burden of supplying SOS current (and consequently, SOS voltage) to the energy storage cell 210 may be shared substantially equally between push current source 410 and the pull current source 420. Accordingly, stresses on the differential current sources 410, 420 may be balanced.

Also, as previously discussed, the SOS current excitation circuitry 400 may be fully high impedance ground isolated. As a result, the analog ground terminal GND may be isolated from the terminals of the energy storage cell 210, protecting the analog ground terminal GND from the high direct current source voltage potentials of the energy storage cell 210, and from external noise sources that may affect the terminals of the energy storage cell 210.

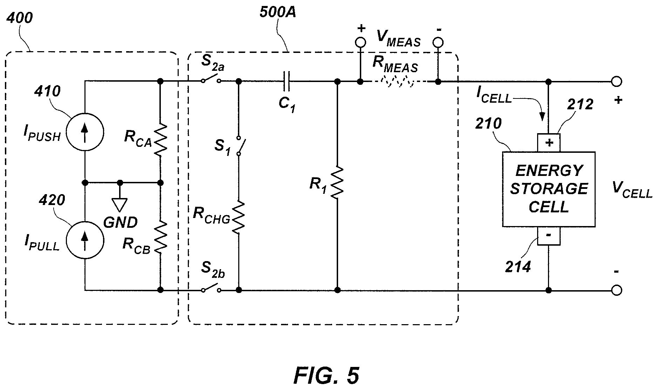

FIG. 5 is a simplified circuit schematic diagram of a high voltage buffer 500A operably coupled to the SOS current excitation circuitry 400 of FIG. 4B, and the energy storage cell 210 of FIG. 2, according to a single coupling capacitor embodiment of the high voltage buffer 500 of FIG. 2. The high voltage buffer 500A may include a high voltage blocking capacitor $C_1$ configured to operably couple between the push current source 410 of the SOS current excitation circuitry 400 and a positive terminal 212 of the energy storage cell 210. The high voltage blocking capacitor $C_1$ may be configured to prevent direct current from the energy storage cell 210 from circulating through the differential current sources 410, 420. The high voltage blocking capacitor $C_1$ may also be configured to prevent the full direct current supply voltage potential provided by the energy storage cell 210 from being applied to the differential current sources 410, 420 (i.e.,

because the differential current sources 410, 420 are only direct current coupled to one of the terminals 212, 214 of the energy storage cell 210). In some embodiments, the high voltage blocking capacitor $C_1$ may instead be operably coupled between the pull current source 420 and the negative terminal 214 of the energy storage cell 210, with similar effect.

With the differential current sources 410, 420 already being high impedance ground isolated, and additionally direct current isolated from one of the terminals 212, 214 of the energy storage cell 210 by the high voltage buffer 500A, the energy storage cell 210 may have a relatively large direct current source voltage potential without applying excessive stress to the differential current sources 410, 420. Accordingly, the differential current sources 410, 420 and the high voltage buffer 500A may be used to measure impedance of energy storage cells 210 having larger direct current source voltage potentials than energy storage cells 210 that conventional impedance measuring systems are capable of measuring. By way of non-limiting example, impedance of energy storage cells 210 having direct current voltage source voltages of greater than about sixty (60) volts may be measured. Also by way of non-limiting example, impedance of energy storage cells 210 having direct current voltage source voltages of at least about three hundred (300) volts may be measured.

The high voltage buffer 500A may also include a resistor $R_1$ operably coupled across the positive terminal 212 and a negative terminal 214 of the energy storage cell 210. The resistor $R_1$ may be configured to provide a discharge path for charge stored on the high voltage blocking capacitor $C_1$.

The high voltage buffer 500A may further include pre-charge control circuitry $S_{2a}$, $S_{2b}$, $S_1$, $R_{CHG}$ configured to pre-charge the high voltage blocking capacitor $C_1$. The pre-charge control circuitry $S_{2a}$, $S_{2b}$, $S_1$, $R_{CHG}$ may include a switch $S_{2a}$ operably coupled to the push current source 410, a switch $S_{2b}$ operably coupled to the pull current source 420, and a control switch $S_1$ operably coupled in series with a pre-charge resistor $R_{CHG}$ configured to selectively operably couple a node between the high voltage blocking capacitor $C_1$ and the switch $S_{2a}$ to the negative terminal 214 of the energy storage cell 210 through the pre-charge resistor $R_{CHG}$.

In a pre-charge operation of the high voltage blocking capacitor $C_1$, the control switch S1 may be closed, and switches $S_{2a}$ and $S_{2b}$ may be opened. As a result, the high voltage blocking capacitor $C_1$ may be charged with a blocking voltage. When the pre-charge operation is complete, the control switch S1 may be opened, and switches $S_{2a}$ and $S_{2b}$ may be closed, enabling an SOS signal 404 to be applied to the energy storage cell 210, and measurements to be performed. At the completion of the measurements, a discharge operation of the high voltage blocking capacitor $C_1$ may be performed, and switches $S_{2a}$ and $S_{2b}$ may be opened. Additional switches (not shown) may disconnect the energy storage cell 210 from the high voltage blocking capacitor $C_1$, which may be discharged.

In some embodiments (e.g., in embodiments where it is desired to measure both a voltage response $V_{CELL}$ and a current response $I_{CELL}$ of the energy storage cell 210), the high voltage buffer 500A may also include a current measuring resistor $R_{MEAS}$ operably coupled to one of the positive terminal 212 and the negative terminal 214 of the energy storage cell 210. In the embodiment illustrated in FIG. 5, the measuring resistor $R_{MEAS}$ is operably coupled to the positive terminal 212 of the energy storage cell 210. The current measuring resistor $R_{MEAS}$ may have a known resistance value to enable the current $I_{CELL}$ through the terminals 212, 214 of the energy storage cell 210 to be measured. For example, a voltage potential $V_{MEAS}$ across the current measuring resistor $R_{MEAS}$ may be measured, and the current $I_{CELL}$ may be computed by dividing the voltage potential $V_{MEAS}$ by the known resistance value of current measuring resistor $R_{MEAS}$. In some embodiments, the resistance value of the current measuring resistor $R_{MEAS}$ may be selected to be relatively small in comparison to other system resistances (e.g., resistive components of the energy storage cell 210, source resistances of the differential current sources 410, 420, parasitic resistances of the high voltage blocking capacitor $C_1$, etc.) to reduce the effects of the current measuring resistor $R_{MEAS}$ on electrical signals 216 at the terminals 212, 214 of the energy storage cell 210. By way of non-limiting example, the resistance value of the current measuring resistor $R_{MEAS}$ may be about fifty (50) milliohms (m$\Omega$).

FIG. 6 is a simplified circuit schematic diagram of a high voltage buffer 500B operably coupled to the SOS current excitation circuitry 400 of FIG. 4B, and the energy storage cell 210 of FIG. 2, according to a double coupling capacitor embodiment of the high voltage buffer 500 of FIG. 2. The high voltage buffer 500B may be similar to the high voltage buffer 500A of FIG. 5, except that the high voltage buffer 500B includes an additional high voltage blocking capacitor $C_2$ operably coupled between the pull current source 420 of the SOS current excitation circuitry 400 and the negative terminal 214 of the energy storage cell 210.

Advantages of the high voltage buffer 500B over the high voltage buffer 500A of FIG. 5 include full direct current decoupling of the differential current sources 410, 420 from the energy storage cell 210 (i.e., because capacitors $C_1$ and $C_2$ decouple the SOS current excitation circuitry 400 from direct current voltage potentials of both of the terminals 212, 214 of the energy storage cell 210). The high voltage blocking capacitors $C_1$ and $C_2$ of the high voltage buffer 500B, however, are effectively operably coupled with each other in series. As a result, a total capacitance would be half of a capacitance value of the high voltage blocking capacitors $C_1$ and $C_2$, assuming that the capacitance values of the high voltage blocking capacitors $C_1$ and $C_2$ are about the same. As a result, the differential current sources 410, 420 operably coupled to the high voltage buffer 500B may be required to support voltage potentials that are about twice as high as the voltage potentials that the differential current sources 410, 420 operably coupled to the high voltage buffer 500A of FIG. 5 may be required to support. These design considerations should be weighed in choosing between using the high voltage buffer 500B of FIG. 6 and the high voltage buffer 500A of FIG. 5.

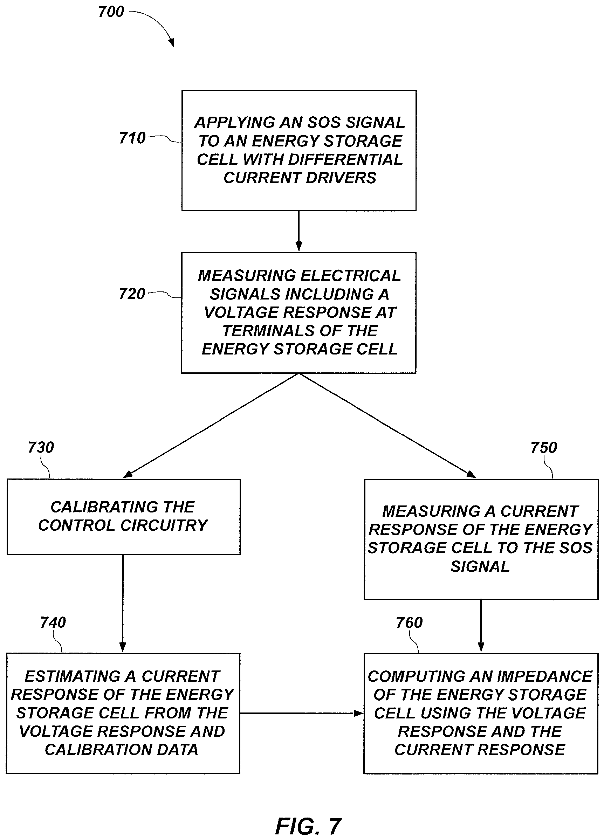

FIG. 7 is a simplified flowchart 700 illustrating a method of measuring impedance of an energy storage cell 210 (FIG. 2). Referring to FIGS. 2 and 7 together, at operation 710, the method may include applying an SOS signal 404 to an energy storage cell 210 with SOS current excitation circuitry 400 including differential current drivers 410, 420 (FIGS. 4A and 4B). In some embodiments, applying the SOS signal 404 may include applying a HOST SOS signal. In some embodiments, applying the SOS signal 404 to the energy storage cell 210 may include applying the SOS signal 404 to the energy storage cell 210 through a high voltage buffer 500, 500A, 500B. In some embodiments, applying the SOS signal 404 may include generating a digital SOS signal 312 (FIG. 3A) with an SOS control module 310 (FIG. 3A), converting the digital SOS signal 312 to a choppy SOS signal 324 (FIG. 3A) with a digital-to-analog converter 320 (FIG. 3A), smoothing the choppy SOS signal 324 with a smoothing filter 330 (FIG. 3A) to generate an SOS control signal 302, and applying the SOS control signal 302 to the SOS current excitation circuitry 400.

At operation 720, the method may include measuring electrical signals 216 including a voltage response $V_{CELL}$ at terminals 212, 214 (FIGS. 5, 6) of the energy storage cell 210. In some embodiments, measuring the electrical signals 216 may include measuring the electrical signals 216 with a signal measuring module 340 (FIG. 3A) of the control circuitry 300, and outputting measured signal data 342 to an impedance computation module 350 (FIG. 3A) of the control circuitry 300.

In some embodiments, at operation 730, the method may include calibrating control circuitry 300 for measuring the electrical signals 216 (e.g., using a single-shunt method of calibrating control circuitry 300 discussed below with reference to FIG. 8, using multiple-shunt calibration, as discussed in W.H. Morrison, J.L. Morrison, J.P. Christophersen, P.A. Bald, An Advanced Calibration Procedure for Complex Impedance Spectrum Measurements of Advanced Energy Storage, San Diego: The International Society of Automation, 2012. 58th International Instrumentation Symposium). In such embodiments, at operation 740, the method may include estimating a current response $I_{CELL}$ of the energy storage cell 210 from the voltage response $V_{CELL}$ and calibration data resulting from the calibration performed at operation 730.

In some embodiments, no calibration of the control circuitry 300 may be needed. In such embodiments, at operation 750, the method may include measuring a current response $I_{CELL}$ of the energy storage cell 210 to the SOS signal 404 (e.g., by measuring a voltage potential $V_{MEAS}$ across a known resistor $R_{MEAS}$ in series with the terminals 212, 214 of the energy storage cell 210, as shown in FIGS. 5 and 6, and dividing the voltage potential $V_{MEAS}$ by the known value of resistor $R_{MEAS}$).

As previously discussed with reference to operations 730 and 740, the current response $I_{CELL}$ may either be estimated using the voltage response $V_{CELL}$ and the calibration data, or, as discussed with reference to operation 750, the current response $I_{CELL}$ may be measured. Whether estimated or measured, the current response $I_{CELL}$ may be substantially the same. If $I_{CELL}$ is estimated, a calibration may be required, but only a single measurement may be required (to measure $V_{CELL}$). On the other hand, if $I_{CELL}$ is measured, no calibration may be required, but an extra measurement may be required (to measure $V_{MEAS}$). Consideration for these advantages and disadvantages should be taken in determining whether to perform the method through operations 730 and 740, or through operation 750.

At operation 760, the method may include computing an impedance of the energy storage cell 210 using the voltage response $V_{CELL}$ and the current response $I_{CELL}$. By way of non-limiting example, the impedance of the energy storage cell 210 may be computed by dividing a frequency component of the voltage response $V_{CELL}$ corresponding to each of the plurality of different frequencies of the SOS signal 404 by a corresponding frequency component of the current response $I_{CELL}$. In some embodiments, computing the impedance of the energy storage cell 210 includes computing the impedance of the energy storage cell 210 using an impedance computation module 350 (FIG. 3A) of the control circuitry 300.

FIG. 8 is a simplified flowchart 800 illustrating an example method of calibrating the control circuitry 300 of the energy storage cell impedance measuring system 200 of FIG. 2. Referring to FIGS. 2 and 8 together, at operation 810 the method may include operably coupling a single shunt to an energy cell impedance measuring system 200. The single shunt may be operably coupled to the push current source 410 and the pull current source 420 in the same way that the energy storage cell 210 is operably coupled to the push current source 410 and the pull current source 420 (e.g., through the high voltage buffer 500), as discussed above (FIGS. 5 and 6). The single shunt may include a single resistive shunt of known resistance.

At operation 820, the method may include applying an SOS signal 404 and an orthogonal SOS signal (not shown) to the shunt, and measuring responses of the shunt to the SOS signal 404 and the orthogonal SOS signal for determining a response of a smoothing filter 330 (FIG. 3A). As used herein, the term "orthogonal SOS signal" refers to a version of the SOS signal 404 that may be expressed by changing any sine signals of the SOS signal 404 to cosine signals, and any cosine signals of the SOS signal 404 to sine signals. For example, if an SOS signal 404 may be described by $I_{SOS\ SIGNAL}$ =

$\sin(\omega t) + \cos(2(\omega t) + \sin(3\omega t)$, the corresponding orthogonal SOS signal may be expressed as $I_{ORTHOGONAL\ SOS}$ = $\cos(\omega t) + \sin(2\omega t) + \cos(3\omega t)$. The SOS signal 404 and the orthogonal SOS signal may both include each of the frequencies of interest for measuring impedance of an energy storage cell 210.

In some embodiments, the SOS signal 404 may include a HOST SOS signal, and the orthogonal SOS signal may be a corresponding orthogonal HOST SOS signal. In some embodiments, the SOS signal 404 may include a sum of sines, and the orthogonal SOS signal may include a sum of cosines. In some embodiments, the SOS signal 404 may include a sum of cosines, and the orthogonal SOS signal may include a sum of sines. Other SOS signals 404 and orthogonal SOS signals may also be applied to the shunt within the scope of the present disclosure.

At operation 830, the method may include determining and applying pre-emphasis parameters (e.g., to the SOS control module 310 of FIG. 3A) to compensate for a determined response of the smoothing filter 330. For example, the control circuitry 300 (FIG. 3A) may be configured to determine, for each frequency component of the SOS signal 404 and the orthogonal SOS signal, magnitude and phase responses. The SOS control module 310 may be configured to compensate for each of these magnitude and phase responses in applying SOS signals 404 and orthogonal SOS signals in operations 840, 850, and 860 that follow.

At operation 840, the method may include applying a first SOS signal and a first orthogonal SOS signal, both having a first magnitude, to the shunt, and measuring first responses of the shunt to both the first SOS signal and the first orthogonal SOS signal.

At operation 850, the method may include applying a second SOS signal and a second orthogonal SOS signal, both having a second magnitude different from the first magnitude, to the shunt, and measuring second responses of the shunt to both the second SOS signal and the second orthogonal SOS signal. By way of non-limiting example, the second magnitude may be half of the first magnitude.

At operation 860, the method may include applying a third SOS signal and a third orthogonal SOS signal, both having a third magnitude different from the first and second magnitudes, to the shunt, and measuring third responses of the shunt to both the SOS signal and the orthogonal SOS signal. In some embodiments, the third magnitude may be twice the first magnitude.

Some conventional calibration techniques utilize multiple different shunts having different resistive and reactive values covering a range of expected impedance values of a test energy storage cell. In contrast, the method illustrated in FIG. 8 simulates multiple shunts by adjusting SOS currents applied to the single shunt. In the example illustrated in FIG. 8, six shunts (three different resistive shunts and three different reactive shunts) are simulated. Specifically, applying the first SOS signal (operation 840) corresponds to a first simulated resistance, applying the second SOS signal (operation 850) corresponds to a second simulated resistance of half the resistance of the first simulated resistance, and applying the third SOS signal (operation 860) corresponds to a third simulated resistance of twice the resistance of the first simulated resistance. Accordingly, by adjusting the magnitude of the first SOS signal, a simulated resistance value of the shunt may be altered in proportion.

Similarly, the first orthogonal SOS signal, the second orthogonal SOS signal, and the third orthogonal SOS signal may correspond to three different simulated reactance values. Relatively low levels of capacitive reactance at relatively low frequencies may be simulated with resistive shunts by providing orthogonal SOS signals, and the simulated reactance values may be altered by altering the magnitude of the applied orthogonal SOS signals.

The example of FIG. 8 should be understood to be an example, and not limiting. Within the scope of the disclosure, an infinite number of different permutations of SOS signals and orthogonal SOS signals (e.g., not limited to a first, a second, and a third SOS signal and orthogonal SOS signal) simulating an infinite number of permutations of simulated impedance values expected for a given energy storage cell may be used.

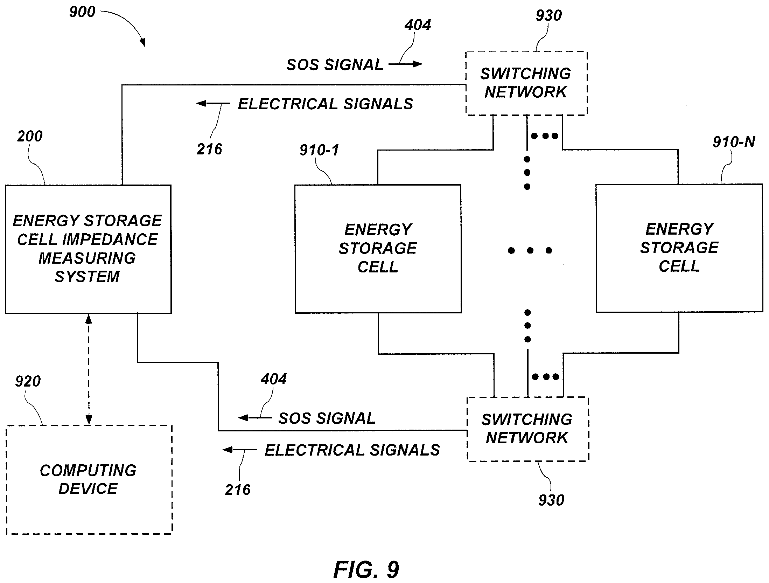

FIG. 9 is a simplified block diagram of an impedance measuring system 900. The impedance measuring system 900 may include an energy storage cell impedance measuring system 200 operably coupled to one or more energy storage cells 910-1, ... 910-N (sometimes referred to hereinafter generally individually as "energy storage cell" 910, and together as "energy storage cells" 910). The energy storage cell impedance measuring system 200 may be similar to that discussed above with reference to FIG. 2. For example, the energy storage cell impedance measuring system 200 may include control circuitry 300, SOS current excitation circuitry 400 including differential current sources 410, 420 (FIGS. 4A and 4B), and a high voltage buffer 500. The energy storage cell impedance measuring system 200 may be configured to provide SOS signals 404 to terminals of the energy storage cells 910, and measure electrical signals 216 (e.g., voltage responses, current responses, etc.) of the terminals. The energy storage cell impedance measuring system 200 may be configured to determine the impedance of the energy storage cells 910 using the electrical signals 216.

In some embodiments, the energy storage cell impedance measuring system 200 may be operably coupled to the energy storage cells 910 through a switching network 930. The switching network 930 may be configured to selectively (manually or automatically) operably couple the energy storage cell impedance measuring system 200 to one of the energy storage cells 910 at a time, if the energy storage cells 910 include multiple energy storage cells. Accordingly, the switching network 930 may be configured to enable the energy storage cell impedance measuring system 200 to measure the impedance of the energy storage cells 900 one at a time. In some embodiments, however, no switching network 930 may be used, and the energy storage cell impedance measuring system 200 may be operably coupled to each of the energy storage cells 910 (e.g., separately). In some embodiments, the energy storage cell impedance measuring system 200 may include multiple energy storage cell impedance measuring systems 200, each operably coupled to one of the energy storage cells 910. In some embodiments, a single energy storage cell impedance measuring system 910 may be operably coupled to each of the energy storage cells 910, and configured to selectively apply SOS signals 404 to and measure the resulting electrical signals 216 from each of the energy storage cells 910 at different times.

In some embodiments, the energy storage cell impedance measuring system 200 may include a computing device 920 operably coupled to the energy storage cell impedance measuring system 200. The computing device 920 may include an external computing device (e.g., a personal computer, a laptop computer, an automobile central processing unit, a tablet computer, a smart phone, etc.). In some embodiments, the computing device 920 may be configured to perform at least some of the functions of the control circuitry 300 (FIG. 3A). For example, the computing device 920 may be configured to receive measured signal data 342 (FIG. 3A), and calculate the impedance of the energy storage cells 910 using the measured signal data 342. In some embodiments, the computing device 920 may be configured to further process impedance data 358 provided by the control circuitry 300. By way of non-limiting example, the computing device 920 may be modified with software to enable a user to interactively view plots, generate reports, and other operations associated with the impedance data 358 (FIG. 3A) provided by the control circuitry 300 of the energy storage cell impedance measuring system 200.

In some embodiments, multiple energy storage cells 910 may be desirable. By way of non-limiting example, some electric or hybrid automobiles may benefit from multiple energy storage cell 910 systems.

In some embodiments, an apparatus powered by the one or more energy storage cells 910 may include the energy storage cell impedance measuring system 200, to enable monitoring of the health of the energy storage cells 910 *in situ.* By way of non-limiting example, an automobile may include the energy storage cell impedance measuring system 200, and the energy storage cells 910. A warning (e.g., visual, audible, or a combination thereof) may be provided when the energy storage cell impedance measuring system 200 detects that one of the energy storage cells 910 should be replaced. The invention is defined by the appended claims.

## Claims

1. An energy storage cell impedance measuring system (200) comprising:

    a sum-of-sinusoids, SOS, current excitation circuit (400) including differential current sources including a first current source (410) and a second current source (420), the differential current sources configured to isolate a ground terminal, GND, of the differential current sources from a positive terminal (212) and a negative terminal (214) of an energy storage cell (210), the SOS current excitation circuit (400) configured to apply an SOS signal (404) through the energy storage cell (210), the SOS signal (404) including a sum of a plurality of sinusoidal current signals, each of the plurality of sinusoidal current signals oscillating at a different one of a plurality of different frequencies; and
    control circuitry (300) configured to operably couple to the SOS current excitation circuit (400), the positive terminal (212), and the negative terminal (214), the control circuitry (300) comprising:

       an SOS control module (310) configured to cause the SOS current excitation circuit (400) to produce the SOS signal;
       at least one signal measuring module (340) configured to measure electrical signals on the positive terminal (212) and the negative terminal (214) of the energy storage cell (210); and
       an impedance computation module (350) configured to use the electrical signals measured by the at least one signal measuring module (340) to compute an impedance of the energy storage cell (210) for each frequency of the SOS signal.

2. The energy storage cell impedance measuring system (200) of claim 1, wherein the plurality of different frequencies include integer harmonic frequencies of a lowest frequency of the plurality of different frequencies.

3. The energy storage cell impedance measuring system (200) of claim 2, wherein the plurality of sinusoidal current signals of the SOS signals include alternating sine and cosine current signals for each successive frequency of the plurality of different frequencies.

4. The energy storage cell impedance measuring system (200) of claim 1, further comprising a high voltage buffer (500) operably coupled between the SOS current excitation circuit (400) and the energy storage cell (210), the high voltage buffer (500) configured to isolate at least one signal line of the SOS current excitation circuit (400) carrying at least a portion of the SOS signal from a direct current voltage potential difference between the positive terminal (212) and the negative terminal (214).

5. The energy storage cell impedance measuring system (200) of claim 4, wherein the high voltage buffer (500) includes a high voltage blocking capacitor ($C_1$) operably coupled between at least one of the differential current sources and at least one of the positive terminal (212) and the negative terminal (214) of the energy storage cell (210).

6. The energy storage cell impedance measuring system (200) of claim 1, wherein the first current source (410) includes a push current source configured to push current into the energy storage cell (210), and the second current source (420) includes a pull current source configured to pull current from the energy storage cell (210).

7. A method of measuring impedance of an energy storage cell (210), the method comprising:

    applying a sum-of-sinusoids, SOS, signal comprising a sum of sinusoidal current signals to an energy storage cell (210) with an SOS current excitation circuit (400) including differential current sources including a first current source (410) and a second current source (420), the differential current sources configured to isolate a ground terminal, GND, of the differential current sources from a positive terminal (212) and a negative terminal (214) of an energy storage cell (210), each of the sinusoidal current signals oscillating at a different one of a plurality of different frequencies;
    measuring an electrical signal at a positive terminal (212) and a negative terminal (214) of the energy storage cell (210); and
    computing an impedance of the energy storage cell (210) at each of the plurality of different frequencies using the measured electrical signal.

8. The method of claim 7, wherein measuring an electrical signal at the positive terminal (212) and the negative terminal (214) comprises:

    measuring a voltage potential response to the SOS signal across the positive terminal (212) and the negative terminal (214) of the energy storage cell (210); and
    measuring a current response to the SOS signal through the energy storage cell (210).

9. The method of claim 8, wherein calculating the impedance of the energy storage cell (210) at each of the plurality of different frequencies comprises dividing a portion of the measured voltage potential response that corresponds to each of the plurality of different frequencies by a portion of the measured current response that corresponds to a same one of the plurality of different frequencies.

10. The method of claim 9, wherein calculating the impedance of the energy storage cell (210) comprises calculating the impedance of the energy storage cell (210) without calibrating control circuitry (300) configured to compute the impedance of the energy storage cell (210).

11. The method of claim 7, further comprising calibrating, using a single shunt of known resistance, control circuitry (300) configured to compute the impedance of the energy storage cell (210), wherein calibrating the control circuitry (300) comprises:

applying a first SOS signal having a first magnitude to the single shunt;
measuring a response of the single shunt to first SOS signal;
applying a first orthogonal SOS signal having the first magnitude to the single shunt; and
measuring a response of the single shunt to the first orthogonal SOS signal.

12. The method of claim 11, wherein calibrating the control circuitry (300) further comprises:

applying a second SOS signal having a second magnitude, different from the first, to the single shunt;
measuring a response of the single shunt to the second SOS signal;
applying a second orthogonal SOS signal having the second magnitude to the single shunt; and
measuring a response of the single shunt to the second orthogonal SOS signal.

13. An impedance measuring system, comprising the energy storage cell impedance measuring system (200) of claim 1 and one or more energy storage cells (210) operably coupled thereto.

14. The impedance measuring system of claim 13, further comprising a switching network (930) configured to selectively operably couple the energy storage cell impedance measuring system (200) to the one or more energy storage cells (210).

15. The impedance measuring system of claim 13, further comprising a vehicle including the one or more energy storage cells (210) and the energy storage cell impedance measuring system (200).

**Patentansprüche**

1. Ein Energiespeicherzellen-Impedanzmesssystem (200), beinhaltend:

eine Sinussummen-Strom-Erregungsschaltung (400), SOS-Strom-Erregungsschaltung, die Differenzstromquellen umfasst, die eine erste Stromquelle (410) und eine zweite Stromquelle (420) umfassen, wobei die Differenzstromquellen konfiguriert sind, um einen Masseanschluss, GND, der Differenzstromquellen von einem positiven Anschluss (212) und einem negativen Anschluss (214) einer Energiespeicherzelle (210) zu isolieren, wobei die SOS-Strom-Erregungsschaltung (400) konfiguriert ist, um ein SOS-Signal (404) durch die Energiespeicherzelle (210) anzulegen, wobei das SOS-Signal (404) eine Summe einer Vielzahl von Sinusstromsignalen umfasst, wobei jedes der Vielzahl von Sinusstromsignalen bei einer unterschiedlichen Frequenz von einer Vielzahl von unterschiedlichen Frequenzen oszilliert; und
einen Steuerschaltkreis (300), der konfiguriert ist, um betriebsfähig an die SOS-Strom-Erregungsschaltung (400), den positiven Anschluss (212) und den negativen Anschluss (214) zu koppeln, wobei der Steuerschaltkreis (300) Folgendes beinhaltet:

ein SOS-Steuermodul (310), das konfiguriert ist, um zu bewirken, dass die SOS-Strom-Erregungsschaltung (400) das SOS-Signal produziert;
mindestens ein Signalmessmodul (340), das konfiguriert ist, um elektrische Signale an dem positiven Anschluss (212) und dem negativen Anschluss (214) der Energiespeicherzelle (210) zu messen; und
ein Impedanzberechnungsmodul (350), das konfiguriert ist, um die von dem mindestens einen Signalmessmodul (340) gemessenen elektrischen Signale zu verwenden, um eine Impedanz der Energiespeicherzelle (210) für jede Frequenz des SOS-Signals zu berechnen.

2. Energiespeicherzellen-Impedanzmesssystem (200) gemäß Anspruch 1, wobei die Vielzahl von unterschiedlichen Frequenzen ganzzahlige harmonische Frequenzen einer niedrigsten Frequenz der Vielzahl von unterschiedlichen Frequenzen umfasst.

3. Energiespeicherzellen-Impedanzmesssystem (200) gemäß Anspruch 2, wobei die Vielzahl von Sinusstromsignalen der SOS-Signale abwechselnde Sinus- und Kosinusstromsignale für jede folgende Frequenz der Vielzahl von unterschiedlichen Frequenzen umfasst.

4. Energiespeicherzellen-Impedanzmesssystem (200) gemäß Anspruch 1, ferner beinhaltend einen Hochspannungspuffer (500), der betriebsfähig zwischen die SOS-Strom-Erregungsschaltung (400) und die Energiespeicherzelle (210) gekoppelt ist, wobei der Hochspannungspuffer (500) konfiguriert ist, um mindestens eine Signalleitung der SOS-Strom-Erregungsschaltung (400), die mindestens einen Teil des SOS-Signals trägt, von einer Gleichstromspannungspotentialdifferenz zwischen dem positiven Anschluss (212) und dem negativen Anschluss (214) zu isolieren.

5. Energiespeicherzellen-Impedanzmesssystem (200) gemäß Anspruch 4, wobei der Hochspannungspuffer (500) einen Hochspannungsblockkondensator ($C_1$) umfasst, der betriebsfähig zwischen mindestens eine der Differenzstromquellen und mindestens einen von dem positiven Anschluss (212) und dem negativen Anschluss (214) der Energiespeicherzelle (210) gekoppelt ist.

6. Energiespeicherzellen-Impedanzmesssystem (200) gemäß Anspruch 1, wobei die erste Stromquelle (410) eine Push-Stromquelle umfasst, die konfiguriert ist, um Strom in die Energiespeicherzelle (210) zu treiben, und die zweite Stromquelle (420) eine Pull-Stromquelle umfasst, die konfiguriert ist, um Strom aus der Energiespeicherzelle (210) zu ziehen.

7. Ein Verfahren zum Messen von Impedanz einer Energiespeicherzelle (210), wobei das Verfahren Folgendes beinhaltet:

   Anlegen eines Sinussummen-Signals, SOS-Signals, beinhaltend eine Summe von Sinusstromsignalen, an eine Energiespeicherzelle (210) mit einer SOS-Strom-Erregungsschaltung (400), die Differenzstromquellen umfasst, die eine erste Stromquelle (410) und eine zweite Stromquelle (420) umfassen, wobei die Differenzstromquellen konfiguriert sind, um einen Masseanschluss, GND, der Differenzstromquellen von einem positiven Anschluss (212) und einem negativen Anschluss (214) einer Energiespeicherzelle (210) zu isolieren, wobei jedes der Sinusstromsignale bei einer unterschiedlichen von einer Vielzahl von unterschiedlichen Frequenzen oszilliert; Messen eines elektrischen Signals an einem positiven Anschluss (212) und einem negativen Anschluss (214) der Energiespeicherzelle (210); und
Berechnen einer Impedanz der Energiespeicherzelle (210) an jeder der Vielzahl von unterschiedlichen Frequenzen unter Verwendung des gemessenen elektrischen Signals.

8. Verfahren gemäß Anspruch 7, wobei das Messen eines elektrischen Signals an dem positiven Anschluss (212) und dem negativen Anschluss (214) Folgendes beinhaltet:

   Messen einer Spannungspotentialantwort auf das SOS-Signal über den positiven Anschluss (212) und den negativen Anschluss (214) der Energiespeicherzelle (210); und
   Messen einer Stromantwort auf das SOS-Signal durch die Energiespeicherzelle (210).

9. Verfahren gemäß Anspruch 8, wobei das Errechnen der Impedanz der Energiespeicherzelle (210) an jeder der Vielzahl von unterschiedlichen Frequenzen das Dividieren eines Teils der gemessenen Spannungspotentialantwort, die jeder der Vielzahl von unterschiedlichen Frequenzen entspricht, durch einen Teil der gemessenen Stromantwort, die einer gleichen der Vielzahl von unterschiedlichen Frequenzen entspricht, beinhaltet.

10. Verfahren gemäß Anspruch 9, wobei das Errechnen der Impedanz der Energiespeicherzelle (210) das Errechnen der Impedanz der Energiespeicherzelle (210) ohne das Kalibrieren des Steuerschaltkreises (300), der konfiguriert ist, um die Impedanz der Energiespeicherzelle (210) zu berechnen, beinhaltet.

11. Verfahren gemäß Anspruch 7, ferner beinhaltend das Kalibrieren, unter Verwendung eines einzelnen Shunts mit bekanntem Widerstand, des Steuerschaltkreises (300), der konfiguriert ist, um die Impedanz der Energiespeicherzelle (210) zu berechnen, wobei das Kalibrieren des Steuerschaltkreises (300) Folgendes beinhaltet:

   Anlegen eines ersten SOS-Signals mit einer ersten Größe an den einzelnen Shunt; Messen einer Antwort des einzelnen Shunts auf das erste SOS-Signal;
   Anlegen eines ersten orthogonalen SOS-Signals mit der ersten Größe an den einzelnen Shunt; und
   Messen einer Antwort des einzelnen Shunts auf das erste orthogonale SOS-Signal.

12. Verfahren gemäß Anspruch 11, wobei das Kalibrieren des Steuerschaltkreises (300) ferner Folgendes beinhaltet:

Anlegen eines zweiten SOS-Signals mit einer zweiten Größe, die sich von der ersten unterscheidet, an den einzelnen Shunt;

Messen einer Antwort des einzelnen Shunts auf das zweite SOS-Signal;

Anlegen eines zweiten orthogonalen SOS-Signals mit der zweiten Größe an den einzelnen Shunt; und

Messen einer Antwort des einzelnen Shunts auf das zweite orthogonale SOS-Signal.

13. Ein Impedanzmesssystem, beinhaltend das Energiespeicherzellen-Impedanzmesssystem (200) gemäß Anspruch 1 und eine oder mehrere Energiespeicherzellen (210), die betriebsfähig damit gekoppelt sind.

14. Impedanzmesssystem gemäß Anspruch 13, ferner beinhaltend ein Schaltnetzwerk (930), das konfiguriert ist, um das Energiespeicherzellen-Impedanzmesssystem (200) selektiv betriebsfähig mit der einen oder den mehreren Energiespeicherzellen (210) zu koppeln.

15. Impedanzmesssystem gemäß Anspruch 13, ferner beinhaltend ein Fahrzeug, das die eine oder die mehreren Energiespeicherzellen (210) und das Energiespeicherzellen-Impedanzmesssystem (200) umfasst.

## Revendications

1. Un système de mesure d'impédance de cellule de stockage d'énergie (200) comprenant :

un circuit d'excitation par courant SOS *(sum-of-sinusoids,* somme de sinusoïdes) (400) incluant des sources de courant différentiel incluant une première source de courant (410) et une deuxième source de courant (420), les sources de courant différentiel étant configurées pour isoler une borne de masse, GND, des sources de courant différentiel par rapport à une borne positive (212) et une borne négative (214) d'une cellule de stockage d'énergie (210), le circuit d'excitation par courant SOS (400) étant configuré pour appliquer un signal SOS (404) à travers la cellule de stockage d'énergie (210), le signal SOS (404) incluant une somme d'une pluralité de signaux de courant sinusoïdaux, chaque signal parmi la pluralité de signaux de courant sinusoïdaux oscillant à une fréquence différente parmi une pluralité de fréquences différentes ; et

une circuiterie de commande (300) configurée pour se coupler fonctionnellement au circuit d'excitation par courant SOS (400), à la borne positive (212), et à la borne négative (214), la circuiterie de commande (300) comprenant :

un module de commande SOS (310) configuré pour amener le circuit d'excitation par courant SOS (400) à produire le signal SOS ;

au moins un module de mesure de signal (340) configuré pour mesurer des signaux électriques sur la borne positive (212) et la borne négative (214) de la cellule de stockage d'énergie (210) ; et

un module de calcul informatisé d'impédance (350) configuré pour utiliser les signaux électriques mesurés par l'au moins un module de mesure de signal (340) pour calculer de manière informatisée une impédance de la cellule de stockage d'énergie (210) pour chaque fréquence du signal SOS.

2. Le système de mesure d'impédance de cellule de stockage d'énergie (200) de la revendication 1, dans lequel la pluralité de fréquences différentes incluent des fréquences harmoniques entières d'une fréquence la plus basse parmi la pluralité de fréquences différentes.

3. Le système de mesure d'impédance de cellule de stockage d'énergie (200) de la revendication 2, dans lequel la pluralité de signaux de courant sinusoïdaux des signaux SOS incluent des signaux de courant de sinus et de cosinus qui alternent pour chaque fréquence successive parmi la pluralité de fréquences différentes.

4. Le système de mesure d'impédance de cellule de stockage d'énergie (200) de la revendication 1, comprenant en outre un tampon haute tension (500) couplé fonctionnellement entre le circuit d'excitation par courant SOS (400) et la cellule de stockage d'énergie (210), le tampon haute tension (500) étant configuré pour isoler au moins une ligne de signal du circuit d'excitation par courant SOS (400) portant au moins une portion du signal SOS par rapport à une différence de potentiel continu entre la borne positive (212) et la borne négative (214).

5. Le système de mesure d'impédance de cellule de stockage d'énergie (200) de la revendication 4, dans lequel le tampon haute tension (500) inclut un condensateur de blocage haute tension ($C_1$) couplé fonctionnellement entre au moins une des sources de courant différentiel et au moins une borne parmi la borne positive (212) et la borne négative (214) de la cellule de stockage d'énergie (210).

6. Le système de mesure d'impédance de cellule de stockage d'énergie (200) de la revendication 1, dans lequel la première source de courant (410) inclut une source de poussée de courant configurée pour pousser du courant jusque dans la cellule de stockage d'énergie (210), et la deuxième source de courant (420) inclut une source de tirage de courant configurée pour tirer du courant depuis la cellule de stockage d'énergie (210).

**7.** Un procédé de mesure d'impédance d'une cellule de stockage d'énergie (210), le procédé comprenant :

l'application d'un signal SOS (*sum-of-sinusoids*, somme de sinusoïdes) comprenant une somme de signaux de courant sinusoïdaux à une cellule de stockage d'énergie (210) avec un circuit d'excitation par courant SOS (400) incluant des sources de courant différentiel incluant une première source de courant (410) et une deuxième source de courant (420), les sources de courant différentiel étant configurées pour isoler une borne de masse, GND, des sources de courant différentiel par rapport à une borne positive (212) et une borne négative (214) d'une cellule de stockage d'énergie (210), chacun des signaux de courant sinusoïdaux oscillant à une fréquence différente parmi une pluralité de fréquences différentes ;
la mesure d'un signal électrique à une borne positive (212) et une borne négative (214) de la cellule de stockage d'énergie (210) ; et
le calcul informatisé d'une impédance de la cellule de stockage d'énergie (210) à chaque fréquence parmi la pluralité de fréquences différentes en utilisant le signal électrique mesuré.

**8.** Le procédé de la revendication 7, dans lequel la mesure d'un signal électrique à la borne positive (212) et la borne négative (214) comprend :

la mesure d'une réponse de tension au signal SOS entre la borne positive (212) et la borne négative (214) de la cellule de stockage d'énergie (210) ; et
la mesure d'une réponse de courant au signal SOS à travers la cellule de stockage d'énergie (210).

**9.** Le procédé de la revendication 8, dans lequel le calcul de l'impédance de la cellule de stockage d'énergie (210) à chaque fréquence parmi la pluralité de fréquences différentes comprend la division d'une portion de la réponse de tension mesurée qui correspond à chaque fréquence parmi la pluralité de fréquences différentes par une portion de la réponse de courant mesurée qui correspond à une même fréquence parmi la pluralité de fréquences différentes.

**10.** Le procédé de la revendication 9, dans lequel le calcul de l'impédance de la cellule de stockage d'énergie (210) comprend le calcul de l'impédance de la cellule de stockage d'énergie (210) sans étalonnage de la circuiterie de commande (300) configurée pour calculer de manière informatisée l'impédance de la cellule de stockage d'énergie (210).

**11.** Le procédé de la revendication 7, comprenant en outre l'étalonnage, en utilisant un unique shunt de résistance connue, de la circuiterie de commande (300) configurée pour calculer de manière informatisée l'impédance de la cellule de stockage d'énergie (210), l'étalonnage de la circuiterie de commande (300) comprenant :

l'application d'un premier signal SOS ayant une première amplitude à l'unique shunt ; la mesure d'une réponse de l'unique shunt au premier signal SOS ;
l'application d'un premier signal SOS orthogonal ayant la première amplitude à l'unique shunt ; et
la mesure d'une réponse de l'unique shunt au premier signal SOS orthogonal.

**12.** Le procédé de la revendication 11, dans lequel l'étalonnage de la circuiterie de commande (300) comprend en outre :

l'application d'un deuxième signal SOS ayant une deuxième amplitude, différente de la première, à l'unique shunt ;
la mesure d'une réponse de l'unique shunt au deuxième signal SOS ;
l'application d'un deuxième signal SOS orthogonal ayant la deuxième amplitude à l'unique shunt ; et
la mesure d'une réponse de l'unique shunt au deuxième signal SOS orthogonal.

**13.** Un système de mesure d'impédance, comprenant le système de mesure d'impédance de cellule de stockage d'énergie (200) de la revendication 1 et une ou plusieurs cellules de stockage d'énergie (210) couplées fonctionnellement à celui-ci.

**14.** Le système de mesure d'impédance de la revendication 13, comprenant en outre un réseau de commutation (930) configuré pour coupler fonctionnellement de manière sélective le système de mesure d'impédance de cellule de stockage d'énergie (200) aux une ou plusieurs cellules de stockage d'énergie (210).

**15.** Le système de mesure d'impédance de la revendication 13, comprenant en outre un véhicule incluant les une ou plusieurs cellules de stockage d'énergie (210) et le système de mesure d'impédance de cellule de stockage d'énergie (200).

**FIG. 1**

200

300

**CONTROL CIRCUITRY**

SOS CONTROL

302

400

**SOS CURRENT EXCITATION CIRCUITRY**

SOS SIGNAL

404

500

**HIGH VOLTAGE BUFFER**

SOS SIGNAL

404

ELECTRICAL SIGNALS

216

210

**ENERGY STORAGE CELL**

*FIG. 2*

**FIG. 3A**

**FIG. 3B**

FIG. 4A

FIG. 4B

FIG. 5

FIG. 6

700

710 — APPLYING AN SOS SIGNAL TO AN ENERGY STORAGE CELL WITH DIFFERENTIAL CURRENT DRIVERS

720 — MEASURING ELECTRICAL SIGNALS INCLUDING A VOLTAGE RESPONSE AT TERMINALS OF THE ENERGY STORAGE CELL

730 CALIBRATING THE CONTROL CIRCUITRY

750 MEASURING A CURRENT RESPONSE OF THE ENERGY STORAGE CELL TO THE SOS SIGNAL

740 ESTIMATING A CURRENT RESPONSE OF THE ENERGY STORAGE CELL FROM THE VOLTAGE RESPONSE AND CALIBRATION DATA

760 COMPUTING AN IMPEDANCE OF THE ENERGY STORAGE CELL USING THE VOLTAGE RESPONSE AND THE CURRENT RESPONSE

*FIG. 7*

800

810

OPERABLY COUPLING A SINGLE SHUNT TO AN ENERGY STORAGE
CELL IMPEDANCE MEASURING SYSTEM

820

APPLYING AN SOS SIGNAL AND AN ORTHOGONAL SOS SIGNAL TO
THE SHUNT AND MEASURING RESPONSES OF THE SHUNT TO THE
SOS SIGNAL AND THE ORTHOGONAL SOS SIGNAL FOR
DETERMINING A RESPONSE OF THE SMOOTHING FILTER

830

DETERMINING AND APPLYING PRE-EMPHASIS PARAMETERS TO
COMPENSATE FOR A DETERMINED RESPONSE OF THE
SMOOTHING FILTER

840

APPLYING A FIRST SOS SIGNAL AND A FIRST ORTHOGONAL SOS
SIGNAL, BOTH HAVING A FIRST MAGNITUDE, TO THE SHUNT, AND
MEASURING FIRST RESPONSES OF THE SHUNT TO BOTH THE
FIRST SOS SIGNAL AND THE FIRST ORTHOGONAL SOS SIGNAL

850

APPLYING A SECOND SOS SIGNAL AND A SECOND ORTHOGONAL
SOS SIGNAL, BOTH HAVING A SECOND MAGNITUDE DIFFERENT
FROM THE FIRST MAGNITUDE, TO THE SHUNT, AND MEASURING
SECOND RESPONSES OF THE SHUNT TO BOTH THE SECOND SOS
SIGNAL AND THE SECOND ORTHOGONAL SOS SIGNAL

860

APPLYING A THIRD SOS SIGNAL AND A THIRD ORTHOGONAL SOS
SIGNAL, BOTH HAVING A THIRD MAGNITUDE DIFFERENT FROM
THE FIRST AND SECOND MAGNITUDES, TO THE SHUNT, AND
MEASURING THIRD RESPONSES OF THE SHUNT TO BOTH THE
THIRD SOS SIGNAL AND THE THIRD ORTHOGONAL SOS SIGNAL

*FIG. 8*

FIG. 9

EP 3 317 683 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 78995915
- US 43874112
- US 9244130 B
- US 21701308
- US 8150643 B
- US 82562907
- US 7395163 B
- US 31354605
- US 63796904
- US 60724631 B
- US 81375010
- US 8868363 B
- US 61186358
- US 77288010
- US 8352204 B
- US 10017011
- US 61330766
- US 10018411
- US 8762109 B
- US 61330733
- US 2014358462 A
- US 20140188414 A
- US 20120262186 A, Morrison

**Non-patent literature cited in the description**

- An Advanced Calibration Procedure for Complex Impedance Spectrum Measurements of Advanced Energy Storage. **W.H. MORRISON ; J.L. MORRISON ; J.P. CHRISTOPHERSEN ; P.A. BALD.** 58th International Instrumentation Symposium. The International Society of Automation, 2012